# EUROPEAN PATENT SPECIFICATION

(11) **EP 4 425 542 B1**
(45) Date of publication and mention of the grant of the patent: **14.01.2026**
(21) Application number: 23159311.2
(22) Date of filing: 01.03.2023
(51) Int. Cl.: H01L 23/00, H10N 69/00

(54) **A METHOD FOR PRODUCING SOLDER BUMPS ON A SUPERCONDUCTING QUBIT SUBSTRATE**
VERFAHREN ZUR HERSTELLUNG VON LÖTHÖCKERN AUF EINEM SUPRALEITENDEN QUBIT-SUBSTRAT
PROCÉDÉ DE PRODUCTION DE BOSSES DE SOUDURE SUR UN SUBSTRAT DE QUBIT SUPRACONDUCTEUR

(43) Date of publication of application: 04.09.2024
(73) Proprietor: Imec VZW, 3001 Leuven (BE)
(72) Inventor: DERAKHSHANDEH, Jaber, 3300 Tienen (BE); ANANTHAPADMANABHA RAO, Vadiraj Manjunath, 3000 Leuven (BE); WAN, Danny, 3000 Leuven (BE); BEYNE, Eric, 3001 Heverlee (BE); DE GREVE, Kristiaan, 3001 Heverlee (BE); POTOCNIK, Anton, 3001 Leuven (BE)
(74) Representative: Patent Department IMEC

(56) References cited:
- US-A1- 2003 155 408
- US-A1- 2007 246 133
- US-A1- 2020 176 409
- US-A1- 2022 359 808

## Description

### Field of the Invention

The present invention is related to the formation of interconnect bumps on a substrate comprising superconducting qubits or parts thereof.

### State of the art.

3D integration of microchips involves the bonding and interconnecting of multiple stacked chips, and/or the bonding and interconnecting of a chip to a larger carrier component such as an interposer or a printed circuit board (PCB). In the field of superconducting (SC) quantum qubits, there is a special interest in 3D integration, as it enables to increase the number and density of qubits by interconnecting the qubits or parts thereof by vertical interconnects. Such vertical interconnects include TSV (through substrate via) connections through the substrate of a qubit chip and/or through an interposer chip. The interconnects between bonded quantum components, for example a chip and an interposer, may be realized by solder bump connections.

A particular difficulty in the field of superconducting qubits is the requirement to use materials having superconducting properties at the cryogenic operational temperature. This is true for the materials used in the qubits as such and also for the TSVs, for any lateral conductors which connect the qubits to the TSVs and for the solder bumps which contact the TSVs and/or the lateral conductors. Suitable materials include Al, Ta, TaN, Ti, TiN, TiW, Ru, Zr, ZrN, Mo, In, Nb, NbTi, NbN, NbTiN, Nb₃Al and others. A suitable material for the solder bumps is indium. Patent application publication document US20200176409A1 for example describes the deposition of indium bumps on a TiN diffusion-barrier layer formed on Al contact pads of a superconducting qubit wafer. The technique described for the formation of the indium bumps is the so-called lift-off technique, wherein a patterned photoresist layer is formed on the qubit wafer, with the pattern defining openings in the resist at the location of the bumps. This is followed by the deposition of indium in the openings and on the resist. The resist is then stripped, leaving indium bumps at the locations of the openings. This lift-off technique is however expensive and only applicable for large bump dimensions. The technique is also not applicable on large wafer sizes such as on standard Si process wafers of 300mm in diameter.

In terms of cost and scalability towards smaller bumps arranged in high density arrays and towards the use of larger wafers, a more preferred technique is electrodeposition. This technique is however problematic in a context of SC materials, given that it requires a low resistive seed layer on the wafer. Often copper is used for this seed layer, but as copper is not a superconducting material, it cannot be used in this way in a SC qubit context. Plating indium directly on a seed layer formed of SC material is also difficult, given that SC materials have very high resistivity at the temperatures applicable for the electrodeposition. As a consequence, bump height will depend on the position of the bump on the wafer: bumps will be higher in lateral areas of the wafer compared to the centre.

Furthermore, direct electrodeposition of indium on SC layers is challenging due to the formation of native oxide on SC layers which is not dissolved in the plating chemistry. The compatibility of the electrodeposition process with qubits, is another challenge. The electrodeposition processes as known in the art are likely to damage the already processed qubit structures.

Patent application publication document US20220359808A1 discloses a method for forming flip chip bumps using electroplating. The method allows the formation of flip chip bumps in a way that is compatible with already-formed sensitive electronic components, such as Josephson junctions, which may be used in quantum processing units. The above described problems are however not addressed in this publication.

Patent application publication document US20030155408A1 discloses a method of producing solder connections, comprising : forming a mask over the top surface of a conductive metal layer with solder bump openings therethrough and etching away the exposed portions of the conductive metal layer below the solder bump openings to form through holes in the conductive metal layer exposing solder bump plating sites on the top surface of the base below the solder bump openings with the conductive metal layer remaining intact on the periphery of the through holes at the solder bump plating sites.

Patent application publication document US20070246133A1 disloses a method for electroplating in which a copper layer is patterned using a resist. A barrier layer lies below the copper layer and is used to supply the electroplating current in regions without the copper layer.

### Summary of the invention

The invention aims to provide a solution to the problems highlighted above. This aim is achieved by a method as disclosed in the appended claims. According to embodiments of the invention, superconducting solder bumps are produced on a qubit substrate by electrodeposition. The substrate comprises qubit areas, each area comprising a superconducting qubit or parts thereof, and the substrate further comprises superconducting contact pads connected to the qubit areas. First a protection layer is formed on the substrate and patterned so as to cover at least the qubit areas. Then one or more thin layers are deposited conformally on the patterned protection layer, said thin layers comprising at least a non-superconducting layer suitable for acting as a seed layer for the electrodeposition of the solder bumps. If more than one thin layer is conformally deposited, i.e. forming a stack of layers, the stack comprises one or more layers of superconducting material and the non-superconducting seed layer forms the top layer of the stack. The seed layer is then removed locally in areas which lie within the surface area of respective contact pads. This is done by producing and patterning a mask layer, so that openings are formed therein, and by removing the seed layer from the bottom of the openings. The solder bumps are formed by electrodeposition of the solder material on at least part of the bottom of said openings. This may be realized by depositing the solder in the openings directly. Alternatively, it may be realized by first removing the mask layer and forming a second mask layer patterned so as to form openings lying within the surface areas of the first openings. After the formation of the solder bumps, the first or second mask layer, the seed layer and the protection layer are removed.

The seed layer conducts current towards the openings at the bottom of which the solder bumps are formed during the electrodeposition. As the seed layer is a non-superconducting layer, it can be realized as a layer that is suitable for this particular purpose of conducting current, i.e. a layer of low resistivity at a temperature applicable during electrodeposition, such as a copper layer, enabling to form solder bumps at the same deposition rate regardless of the position of the bumps on the wafer. Bumps of essentially equal height can thereby be formed regardless of whether the bump locations are closer to or further from the edge of the wafer. At the same time, as the seed layer is first removed locally, and completely removed after the bump formation, no or very little of the seed layer material enters the solder bumps so that the superconducting properties of the bumps are maintained. The method involves multiple lithography and etch steps, which are however not detrimental to the qubit areas, as these areas are protected by the patterned protection layer. This is preferably an organic layer that is removable by a solvent selectively with respect to the qubit metals.

The invention is, in particular, related to a method for producing solder bumps formed of a superconducting solder material on a substrate, the substrate comprising:
- a plurality of superconducting qubits or parts thereof,
- a plurality of contact pads formed of superconducting material, each pad being electrically connected to one or more of said qubits or qubit parts,
the method comprising the steps of:
- producing a protection layer on the substrate and patterning said protection layer so that the qubits and/or qubit parts are covered by the protection layer, while the contact pads are at least partially exposed, wherein the patterned protection layer has a given topography,
- producing a non-superconducting seed layer on the substrate, said seed layer following the topography of the patterned protection layer, said seed layer being suitable as an electrically conductive layer that enables to conduct current in an electrodeposition process,
- producing a mask layer on the seed layer, and patterning the mask layer so as to form openings therein, the surface area of said openings lying within respective exposed areas of the contact pads,
- removing the material of the seed layer from the bottom of said openings,
- thereafter, depositing the superconducting solder material by electrodeposition on at least part of the bottom of the respective openings thereby forming the solder bumps,
- removing the mask layer,
- after the electrodeposition, removing the seed layer and the protection layer.

**In** the method set out in the previous paragraph, the steps are not necessarily performed in the sequence in which they are listed, unless explicitly stated or implicitly clear from the applied wording. **In** particular, the step of removing the mask layer does not necessarily take place after the electrodeposition step. As will be described in the detailed description, the removal of the mask layer may be followed, according to some embodiments, by the formation and patterning of a second mask layer defining smaller openings than the first openings, after which the solder is deposited on the bottom of smaller openings. **In** the above formulation therefore, the electrodeposition can be said to be performed to the effect that the solder material is deposited on at least part of the bottom of the openings in the mask layer, after the removal of the seed layer in said openings.

According to an embodiment, the electrodeposition step is performed directly after the removal of the material of the seed layer from the bottom of said openings, so that the seed layer contacts the bumps in a peripheral area thereof, and the mask layer is removed after the formation of the solder bumps.

According to another embodiment:
- the mask layer is a first mask layer and the openings formed therein are first openings,
- the first mask layer is removed after the step of removing the material of the seed layer from the bottom of said first openings,
- after removing the first mask layer, a second mask layer is produced, wherein the second mask layer is patterned so as to form second openings therein, the surface area of the second openings lying within the surface area of the respective first openings, so that the seed layer is separated from the bottom of the second openings by the material of the second mask layer,

- the electrodeposition step is performed directly after the formation and patterning of the second mask layer, on the bottom of the second openings, so as to form solder bumps which are not in contact with the seed layer,
- the second mask layer is removed after the formation of the solder bumps, followed by the removal of the seed layer and of the protection layer.

According to an embodiment, the method further comprises the step of producing a layer of superconducting material directly on the substrate after the formation and patterning of the protection layer and prior to the formation of the seed layer, said layer of superconducting material following the topography of the patterned protection layer, so that the layer of superconducting material is exposed at the bottom of the openings, and the solder material is deposited on the layer of superconducting material, wherein the layer of superconducting material outside the bumps is removed after the removal of the seed layer.

According to an embodiment, the layer of superconducting material is a barrier layer configured to stop diffusion of solder material into the contact pads.

According to an embodiment, the protection layer is patterned so as to form openings therein, the surface area of said openings lying within the surface area of the contact pads.

In the latter embodiment, the surface area of the openings in the mask layer may be lying within the surface area of the openings in the protection layer. Alternatively, the surface area of the openings in the mask layer may be larger than the surface area of the openings in the protection layer, so that said openings in the mask layer fully overlap the openings in the protection layer.

According to an embodiment, the protection layer is patterned so as to cover only the qubits or parts thereof.

The method may further comprise the production of a plurality of spacer bumps.

According to embodiments of the invention, the seed layer is formed of copper and/or the solder material is indium.

### Brief description of the figures

Figure 1 shows a top view of a superconducting qubit wafer, and an enlarged image of a region comprising an array of qubit areas.
Figure 2 is a section view of a portion of the enlarged region, comprising three adjacent qubit areas.
Figure 3 illustrates the formation of a protection layer on the qubit wafer.
Figures 4 to 14 illustrate key steps of the method of the invention, according to a first embodiment.
Figures 15 to 19 illustrate a second embodiment of the method of the invention.
Figures 20 to 28 illustrate a third embodiment of the method of the invention.
Figures 29 to 31 illustrate a fourth embodiment of the method of the invention.
Figures 32 to 37 illustrate the formation of spacer bumps combined with the method according to the first embodiment.
Figures 38 and 39 illustrate the bonding process of two qubit components, each comprising spacer bumps and solder bumps produced in accordance with the invention.

### Detailed description of the invention

In the following detailed description, all references to specific materials and dimensions are included by way of example only, and none of these citations are to be construed as limitations of the protection scope.

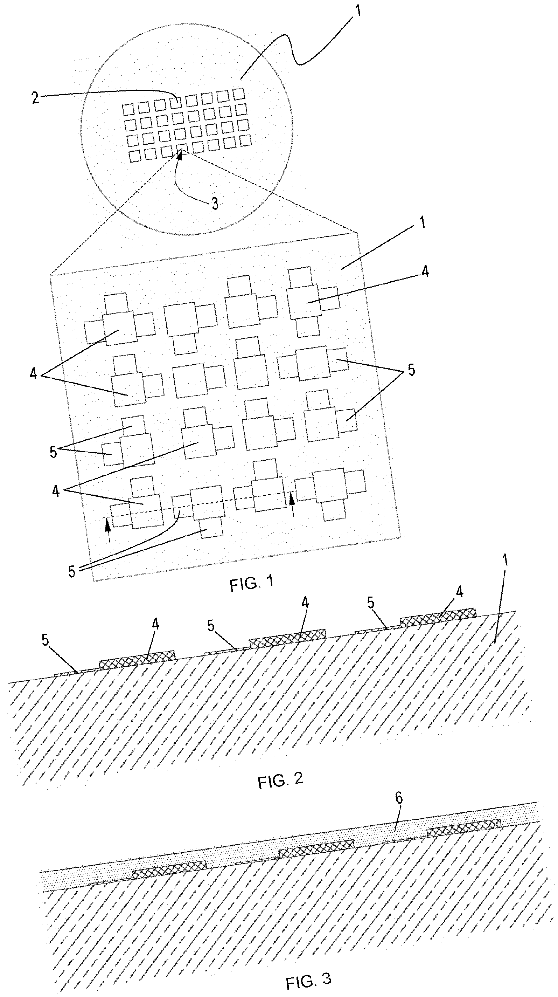

Figure 1 shows a top view of a superconducting qubit wafer 1, defined in the present context as a substrate destined to be divided into a plurality of SC qubit chips and/or qubit interposer chips. The outline of a number of such qubit chips 2 is indicated. The wafer 1 may be a silicon process wafer of diameter 200 mm or 300 mm. Within the surface area of the chips 2, SC qubit elements have been processed according to specific layouts. On the scale of the top view of the full wafer 1, these elements are not distinguishable. Therefore, a square 3 of about 1 X 1mm is represented in an enlarged view. On this square area, 16 SC qubit areas 4 have been processed, arranged in a regular 2-dimensional array. A qubit area 4 may contain all the elements of an SC qubit, such as a Josephson junction, a capacitor, a waveguide, and a resonator. These elements are not shown, as they are well known to the skilled person. Fabrication methods for producing these elements are equally known as such. Some or all of the qubit areas 4 could contain only parts of an SC qubit, to be connected or capacitively coupled to the remaining parts processed on a second qubit wafer or chip that is to be bonded to the illustrated wafer by solder bonding.

Contact pads 5 are illustrated also in the enlarged view in Figure 1. These are represented as patches of superconducting material, for example Al, electrically connected to a qubit area 4. These contact pads 5 are configured to receive solder bumps thereon, in accordance with the method of the invention, of which a number of embodiments will be described in the following paragraphs. The representation of the contact pads 5 as rectangular areas adjacent the qubit areas 4 does not necessarily correspond to a realistic representation of the contact pads. It is intended merely to give a rough indication of possible locations of the solder bumps relative to the qubit areas 4. For example, there may additionally be conductors on the wafer surface which interconnect a number of qubit areas and/or which connect contact pads to one or more qubit areas not directly adjacent the contact pads. Such layouts are known as such and therefore not shown in the drawings.

Figure 2 is a section view of three qubit areas 4 and respective contact pads 5 connected thereto. The represented thickness of these areas is not necessarily in accordance with realistic qubit elements and conductors and intended only to visualize the location of the areas in question. The qubit areas and contact pads 5 are shown as being in direct contact with the Si wafer 1. In reality these elements could be formed on one or a stack of intermediate layers formed on the Si.

A protection layer 6 is produced on the qubit wafer, as illustrated in Figure 3, covering the qubit areas 4 and contact pads 5. This is a layer that can be patterned by lithography alone or by lithography and etching. The protection layer 6 is removable without damaging the qubit elements in the areas 4. According to preferred embodiments, it is an organic photoresist layer, removable by a solvent.

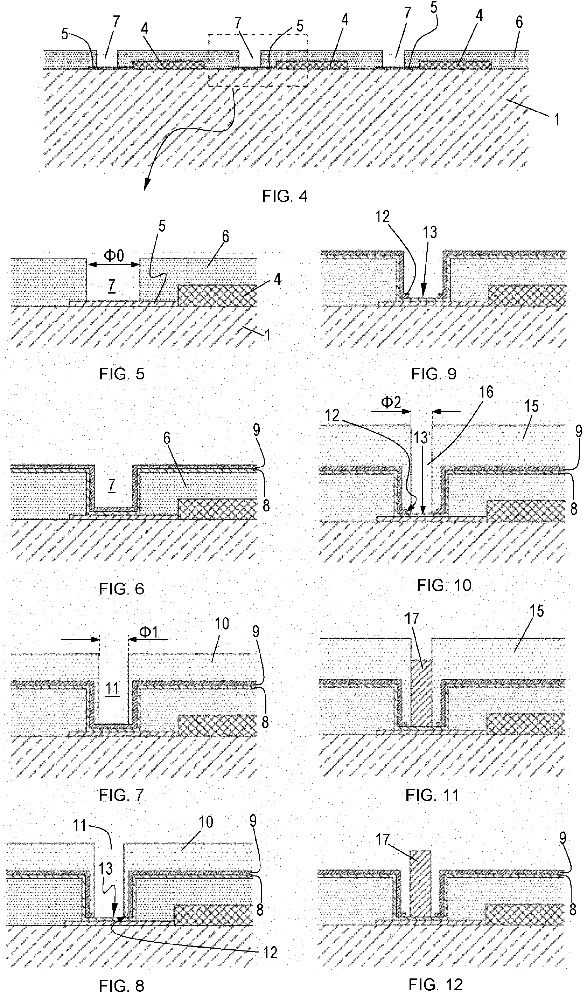

A first embodiment of the method of the invention will now be described with reference to Figures 4 to 12. As seen in Figure 4, the protection layer 6 is patterned. In the case of a photoresist layer, this may be done by illuminating the layer 6 through a lithographic mask, developing the layer and removing illuminated or non-illuminated areas depending on the type of resist used for layer 6. In the embodiment shown, the pattern comprises openings 7 in the protection layer 6, the surface area of said openings 7 lying within the surface area of respective contact pads 5. The openings 7 define future positions of solder bumps which are to be produced in accordance with the invention. The pattern may include additional openings which are not aligned to contact pads 5 and which are intended to define the location of spacer bumps, as will be described later in this description. The focus will however first be on the formation of solder bumps, which represents the main characteristic of the invention. In the exemplary embodiment shown, the openings 7 have a circular cross-section with a diameter φ0 in the order of 20 to 30 µm. Other dimensions and shapes are however possible within the wider scope of the invention. The patterning step results in the protective layer 6 having a topography defined by the openings 7.

Figure 5 is an enlarged detail of an area comprising one of the openings 7 formed in the protection layer 6. The steps described hereafter are performed across the full qubit wafer, i.e., on each of the contact pads 5 which are to receive a solder bump thereon.

In the following, specific materials are cited for a number of elements and/or layers. These materials are merely intended as examples on the basis of which the invention is described, and indications will be given as to other applicable materials later in this description.

In the exemplary configuration described hereafter, the metal used for the Josephson junctions and other qubit elements in the qubit areas 4 and for the contact pads 5 is aluminium, known to have superconducting properties at the cryogenic operational temperature of an SC qubit processor. With reference to Figure 6, a thin diffusion barrier layer 8, which may be formed for example of TiN or TiW, is deposited conformally on the full wafer surface, i.e. this layer follows the topography of the patterned protection layer 6, so that the barrier layer 8 is deposited on the sidewalls and bottom of the openings 7 as well as on the upper surface of the protection layer 6. Like Al, this barrier layer has superconducting properties at the SC qubits' operational temperature. Layer 8 will serve as a diffusion barrier between SC layers of the qubit and the indium solder bump to prevent consumption of solder and qubit SC metal over the product time (shelf life) and during possible next processing steps such as bonding. The barrier layer 8 may be between 10 and 100nm in thickness for example. As the diameter of openings 7 is 20-30µm, the thickness of layer 8 as represented in the drawing is much higher than 100nm, in order to visualize the layer, but in reality, this layer is much thinner than shown, in comparison with the dimensions of the openings 7.

Then a copper layer 9 is conformally deposited on top of the barrier layer 8, having a thickness in the same order of magnitude as the barrier layer. Copper is a non-superconducting material, and has very low resistivity at room temperature. The copper layer is therefore suitable to serve as a seed layer for electrodeposition of the solder bump material. The barrier and Cu layers 8 and 9 cover the wafer completely, up to the edge of the wafer 1.

The barrier and Cu layers 8 and 9 may be deposited by known techniques, such as physical vapour deposition (PVD) or chemical vapour deposition (CVD), preferably applied in the same reactor without breaking the vacuum, so that oxide formation on the barrier layer 8 is minimized.

Then a second photoresist layer 10 is formed on the wafer, and patterned, as illustrated in Figure 7. This resist layer will hereafter be referred to as a mask layer, in accordance with the terminology used in the appended claims. Instead of a resist layer, it could be any layer that is patternable by lithography and/or etching. The pattern of this mask layer 10 contains openings 11 above the contact pads 5. The surface area of the openings 11 lies within the surface area of the contact pads 5 and within the surface area of the bottom of the openings 7 in the protection layer 6, which are now lined with the barrier and Cu layers 8 and 9. In the embodiment shown, the openings 11 have a circular cross-section having a diameter ϕ1 that is smaller than φ0. The difference between ϕ0 and ϕ1 may be in the order of 1µm or smaller depending on the litho tool overlay accuracy.

With reference to Figure 8, the Cu is then removed from the bottom of the openings 11 in the mask layer 10 by a suitable etch process. This may be a wet etch process known as such in the art, and configured to remove the Cu essentially anisotropically, so that the Cu remains under the mask layer 10. After the Cu etch, the Cu layer 9 is exposed along a ring-shaped area 12 around the periphery of the bottom 13 of the openings 11, the surface of said bottom being formed of material of the barrier layer 8. The Cu etch process is preferably selective to the barrier layer 8, so that the process stops on this layer 8. Alternatively, a timed etch is used based on the known thickness of the Cu layer 9. In any case, the wet etch is configured also to remove any native oxides from the barrier layer 8 on the bottom 13 of the openings 11.

Then the mask layer 10 is stripped, as illustrated in Figure 9, which is followed by the formation and patterning of a second mask layer 15, illustrated in Figure 10. The pattern of the second mask layer contains openings 16 whose surface area lies within the surface area of the openings 11 in the first mask layer 10, i.e. within the surface area of the bottom 13 of the first openings 11. The diameter of the second openings ϕ2 is smaller than the diameter of the first openings ϕ1, the difference between ϕ1 and ϕ2 being in the order of 1µm or smaller depending on the litho tool overlay accuracy. As is visualised in Figure 10, this means that the material of the second mask 15 now separates the ring 12 of Cu from the bottom 13' of the second openings 16.

The wafer is then preferably subjected to a cleaning treatment which may be done by exposure to O₂ plasma for example, for removing any residuals remaining after the patterning of the second mask layer 15. If the second mask layer 15 is hydrophobic, the O₂ plasma treatment renders this mask layer 15 hydrophilic, which is required for the wafer to be applicable in the subsequent electroplating process.

With reference to Figure 11, electroplating is then performed, using indium as the solder material in an electroplating tool known as such. In such a tool, the wafer is contacted from the sides at a plurality of contact points along the wafer's circumference, from which a current flows through the Cu seed layer 9, while the wafer is submerged into an electrolytic bath comprising an indium-containing electrode or an inert electrode combined with an indium-containing electrolyte solution. Indium ions are attracted to the exposed surface at the bottom 13' of the openings 16 and form an indium solder bump 17 thereon, as illustrated in Figure 11. The electrodeposition process is known as such. This embodiment of the invention enables the use of this known process for the formation of superconducting solder bumps 17 of equal height on a SC qubit wafer, without any copper entering the solder bumps 17. During the electrodeposition process, the Cu seed layer 9 forms a low resistive path for the electrodeposition current across the full surface of the wafer, enabling the deposition of indium at the same rate on all the bump locations, so that all the bumps essentially have the same height at the end of the electrodeposition process. While the Cu seed layer 8 enables this formation of indium bumps at the same rate across the wafer, there is no direct contact between the Cu and the indium bumps, because of the difference in diameters ϕ1 and ϕ2: because of this difference, the material of the second mask 15 separates the ring 12 of Cu from the bottom 13' of the openings 16. In this way, no copper nor any copper-containing intermetallic compounds are included in the bumps 17. The indium bump height can for example be between 5 µm and 50µm depending on the required gap between two bonded dies or wafers.

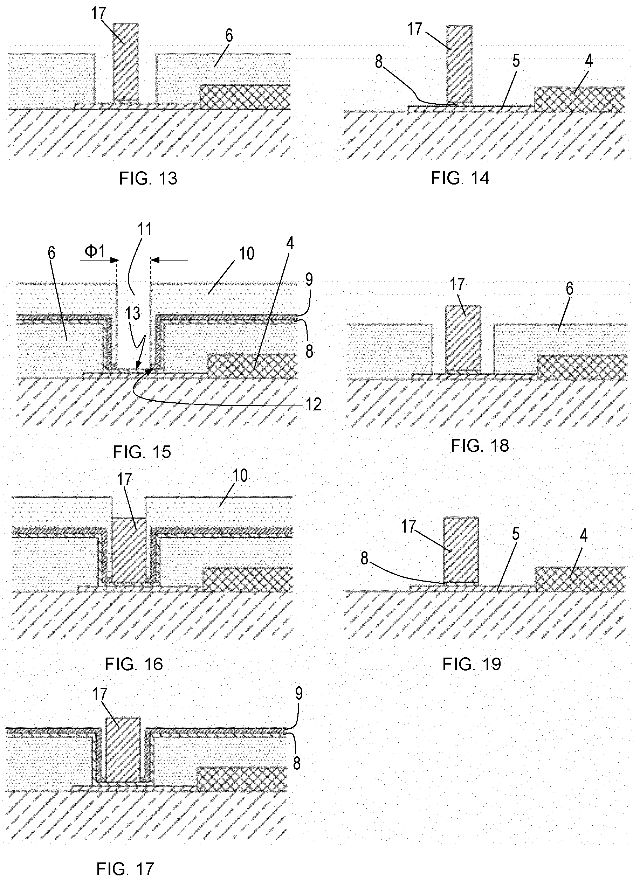

After the bump formation, the second mask layer 15 is stripped, as illustrated in Figure 12. Thereafter, the Cu layer 9 and the barrier layer 8 are removed outside the bumps 17 by wet etching selectively with respect to the indium bumps 17, as illustrated in Figure 13. The etching of the barrier layer 8 is also selective relative to the qubit SC layer of the contact pads 5. In the final step, the protection layer 6 is removed by a solvent, as illustrated in Figure 14, leaving the bumps 17 in electrical contact with the contact pads 5 via a remaining portion 8 of the barrier layer 8 and ready to be bonded to corresponding bumps on a second wafer or chip.

As stated, the embodiment described above is configured so that no copper enters the bumps 17. According to other embodiments, a limited direct contact between the copper and the solder material during electrodeposition is allowed or even desirable, as will be explained hereafter. Such an embodiment is first described as an alternative to the first embodiment, using the same materials and dimensions. The steps of the method according to this second embodiment are the same as in the previous embodiment, up to the point where the Cu is removed in the openings 11 in the first mask layer 10, exposing the bottom 13 of the openings 11, the surface of said bottom 13 being formed of barrier layer material. This situation is represented again in Figure 15. Now however, instead of removing the first mask 10 and depositing a second mask, the electrodeposition step is performed on the configuration shown in Figure 15. Preferably an O₂ plasma treatment is first performed for cleaning bottom 13 and rendering the mask layer 10 hydrophilic. The electrodeposition is then performed, resulting in the bumps 17 of diameter ϕ1, as illustrated in Figure 16, followed by the removal of the mask layer 10, the wet etching of layers 8 and 9 and the removal by a solvent of the protection layer 6, as illustrated in Figures 17 to 19. The difference with the previous embodiment is that the bumps 17 are in direct contact with the Cu ring 12 circumventing the bottom 13 of the openings 11. This has an influence on the plating process, in that the formation of indium is initiated not only on the bottom 13, but also along the circumference of said Cu ring 12, leading to the formation of copper and/or copper-containing intermetallic compounds in a lower peripheral area of the bump, together with the formation of pure indium in the central area of the bump. As long as said central area is wide enough (preferably between 2µm and 100µm), the presence of the Cu-containing peripheral area does not significantly deteriorate the superconducting characteristics of the bump. Whether or not this embodiment is applicable may therefore depend on the dimensions of the bumps, the type of barrier layer material and on the degree of copper formation in the bumps.

In some cases, however, the exposure to copper is required in order to initiate the plating process. For example, plating of indium directly on aluminium is not possible, so if the surface area of the bottom 13 of openings 11 is formed of aluminium, or if no barrier layer is applied, the exposure of the Cu ring 12 is actually required in order to initiate the electrodeposition. Once again however, it is believed that especially for larger bump sizes, this will lead only to the inclusion of copper in a peripheral area of the bump, which will therefore not deteriorate the superconducting properties of the bump in a significant manner.

In either one of the embodiments described above, the diameter ϕ1 of the openings 11 could be larger than the diameter φ0 of the openings 7, and overlapping said diameter ϕ1. In that case, the copper would be removed not only at the bottom of the openings 11 but also from the sidewalls and from a ring-shaped area on top of the protection layer 6. If only one mask is used as in the embodiment of Figures 15-19, this would lead to a mushroom shaped bump 17, which may be acceptable depending on the overall bump dimensions. This embodiment would have the advantage that the removal of the copper and the barrier material after the bump formation cannot adversely affect the SC contact pad 5. This variant is not always possible, and is for example prohibited in cases where the ring of Cu 12 is needed at the bottom of the opening 11, in order to initiate the electrodeposition of the solder material, as in the case of indium solder deposited in openings 11 having Al on the bottom surface.

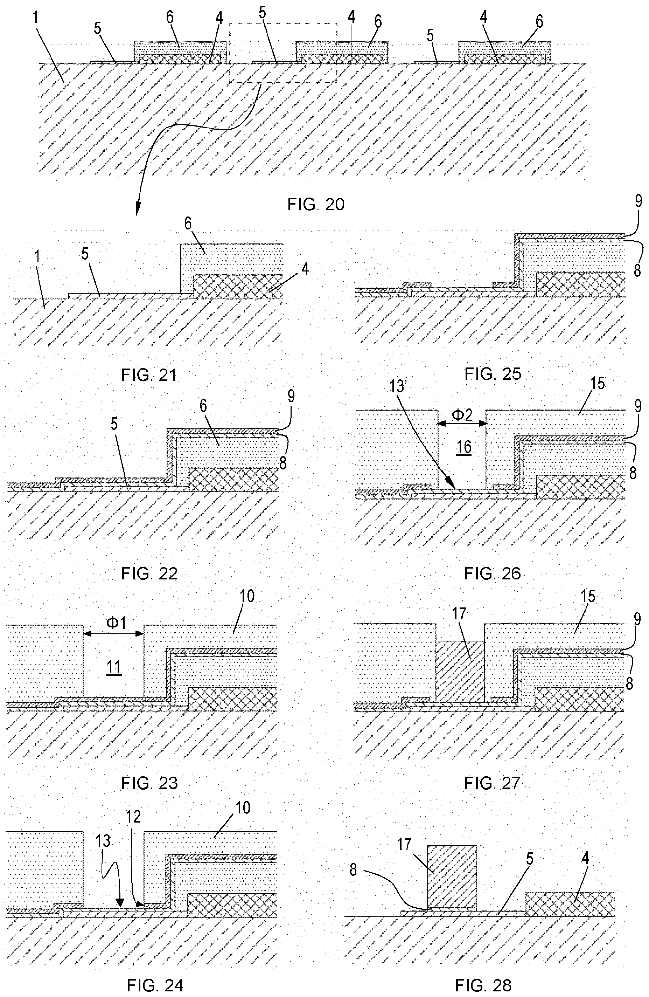

A third embodiment of the method of the invention is illustrated in Figures 20 to 28. As seen in Figure 20, the protection layer 6 is now patterned in a different way compared to the previous embodiments, leading to a different topology of the patterned layer 6. The material of the protection layer 6 is removed everywhere except on the qubit areas 4, i.e., the contact pads 5 are left essentially exposed. Apart from this, the remaining steps are basically the same as in the first embodiment : the conformal deposition of the barrier and Cu layers 8 and 9 (Figure 22), the formation and patterning of the first mask layer 10, comprising openings of diameter ϕ1 above the contact pads 5 (Figure 23), the removal of Cu from the bottom of said openings 11 (Figure 24), leaving a ring 12 of Cu around the circumference of the bottom 13, the stripping of the first mask layer 10 (Figure 25), the formation and patterning of the second mask layer 15, comprising openings 16 above the contact pads, the openings 16 having a diameter ϕ2 < ϕ1, the electrodeposition step (preferably after O₂ plasma treatment) to form the bumps 17 (Fig. 27), and the removal of the second mask layer 15, the wet etching of Cu and barrier layers 9 and 8 outside the bumps 17, and the removal by solvent of the protection layer 6 (Fig. 28).

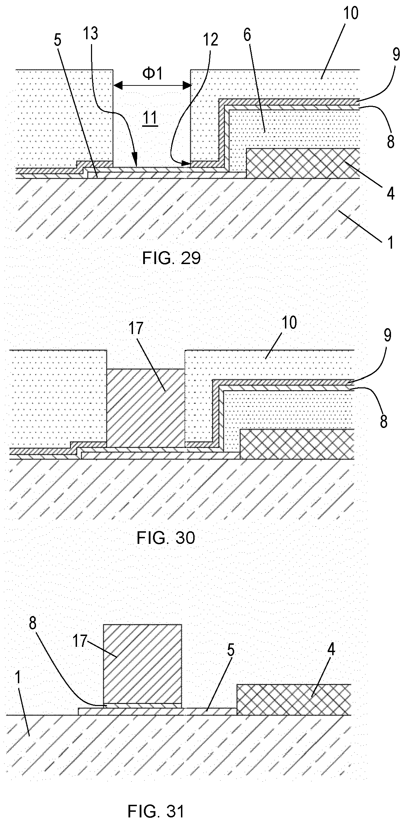

A variation on the latter embodiment, said variation being analogous to the second embodiment, is illustrated in Figures 29 to 31: the electrodeposition is done after forming the first mask layer 10 and openings 11, i.e., with the Cu ring 12 contacting the indium bumps 17, so that Cu enters the bumps in a peripheral area thereof. Again, the latter embodiment is acceptable depending on the dimensions and materials chosen, and may be required for certain material combinations, such as the electrodeposition of indium on aluminium.

As stated above, the invention is not limited to the cited materials. In the description of the above embodiments for example, Al may be replaced by other suitable superconducting materials, and Cu may be replaced by other suitable non-superconducting low-resistive metals such as Pt, Au...

Likewise, the invention is applicable for the formation of solder bumps within a wide range in terms of their lateral dimensions, i.e. the diameter in case of bumps having a circular cross-section or for example the length of the diagonal in case of bumps having a rectangular cross-section. For example, circular bumps of diameters between about 2 µm and about 50 µm are obtainable by the various embodiments of the invention. The actual size depends on the required layout and connectivity of the stacked SC qubit chips. The smaller bumps of this range can be placed close together to form high density arrays of solder bumps, which cannot be achieved with the known lift-off technique.

The height of the bumps is determined in accordance with their lateral size, and is chosen in accordance with the bonding process by which the bumps are to be connected to corresponding bumps or contact pads on another component.

The deposition of the SC layer 8 prior to depositing the Cu layer 9 is required in the case of indium solder bumps 17 and Al contact pads 5, to serve as a diffusion barrier. When the contact pads 5 are formed of an inert SC material such as TiN or NbN, no barrier layer is needed and the Cu layer 9 can be deposited directly on the contact pads 5. The Cu is then removed locally as described above according to any embodiment of the invention, and the indium bumps 17 are formed by electrodeposition directly on the contact pads 5.

A SC qubit component provided with SC solder bumps 17 produced according to the method of the invention, can be bonded to another component by a bonding process that is itself not an object of the invention, i.e. various bonding sequences known in the art may be applied. The component may be a qubit chip obtained by dicing the above-described qubit wafer, wherein the chip is bonded to an interposer chip, equally obtained from said wafer or from another wafer. Another scenario may involve an interposer chip that is bonded to a PCB board, or a chip that is bonded to a full wafer in a die-to-wafer bonding process, or full wafers being bonded in a wafer-to-wafer bonding process. All of these bonding processes involve the alignment of the solder bumps on one component to similar bumps or to contact pads on the other component, followed by the interconnection and heating of the aligned bumps or of the aligned bumps and contact pads so that the solder material melts or softens and forms a solid connection after cooling.

During bonding, it is important to control the distance between two bonded components. A known solution to this is the inclusion of spacer bumps on the two components. These are bumps formed of a hard material, i.e. a material that does not melt or soften at the melting temperature of the solder bumps, and which are aimed at defining the final distance between the components as they are brought together. This distance is defined by the spacer bumps coming into mutual contact and stopping a further mutual approach of the components. The spacer bumps are distributed across the full surface of the component, preferably including at least some spacer bumps in the vicinity of the outer edge of at least one of the components.

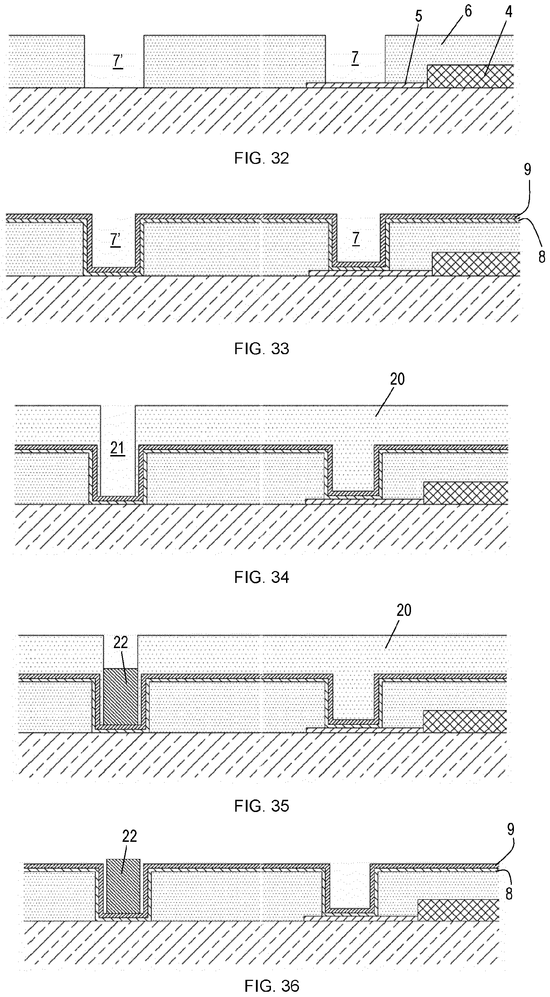

The spacer bumps can be produced according to any known method, including by electrodeposition. One example of a way in which this can be realized is illustrated with reference to Figures 32-37. These images illustrate the production of spacer bumps as well as solder bumps on a qubit wafer, wherein the solder bumps are produced according to the embodiment of Figures 4-14. As seen in Figure 32, a plurality of additional openings 7' are formed in the protection layer 6, at the intended locations of the spacer bumps. In the example shown, the diameters of the additional openings 7' is the same as the diameter of the openings 7, but these diameters may be different from each other.

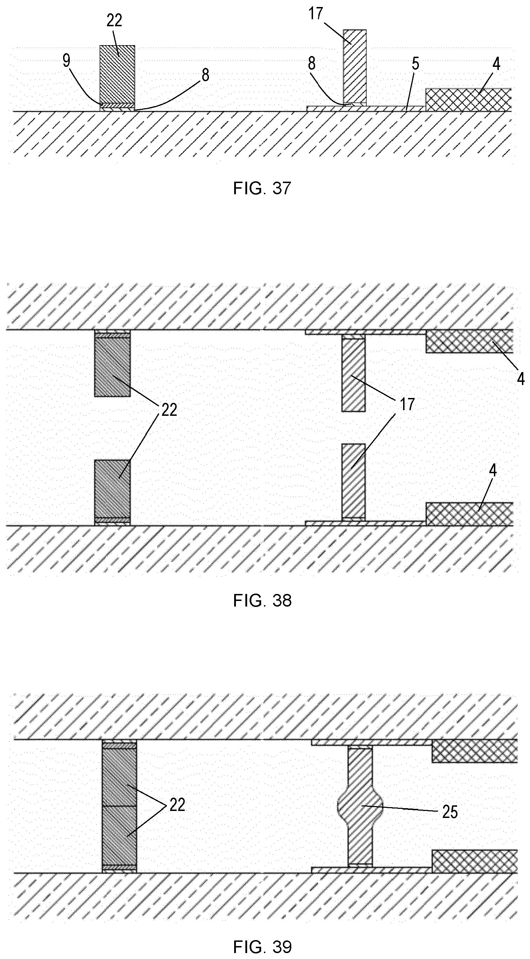

Then (as shown in Figure 33) the barrier layer 8 and the Cu layer 9 are deposited as in the first embodiment. These layers now conformally cover the sidewalls and the bottom of the additional openings 7'. A mask layer 20 is then formed and patterned, see Figure 34, comprising openings 21 whose surface area lies within the surface area of the openings 7'. The bottom of the openings 21 is formed by a central portion of the Cu layer 9. This is followed preferably by a cleaning step such as an O₂ plasma treatment for removing resist residuals and rendering the mask layer 20 hydrophilic. Then electrodeposition of the spacer bump material, for example copper is performed, forming Cu spacer bumps 22 in the openings 21, as illustrated in Figure 35. The mask layer 20 is then stripped, see Figure 36. After this, the indium bumps 17 are produced by the steps illustrated in Figures 7 to 14, resulting in the image shown in Figure 37: indium solder bumps 17 and Cu spacer bumps 22 are formed on the wafer surface. The solder bumps 17 are higher than the spacer bumps 22. As known in the art, this is required so that solder bumps can melt or soften and merge to a certain extent, before the spacer bumps define the final distance between the two bonded components. This known bonding process is illustrated in Figures 38 and 39 : first the components are aligned (Fig. 38). Then the bonding takes place (Fig. 39), resulting in a solder connection 25 formed of the merged solder bumps, and with the spacer bumps 22 in head-to-head contact.

Spacer bumps 22 are required especially when the solder bumps 17 are small in size. When the solder bumps are in the higher part of the range described above, e.g. 30-50 µm in diameter, it may be possible to omit spacer bumps as the softened solder bumps may be able to provide sufficient stability during bonding so that the distance between the components can be sufficiently controlled. Therefore, the invention is not limited to configurations including spacer bumps.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. The invention is defined by the appended claims.

In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

Unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A method for producing solder bumps (17) formed of a superconducting solder material on a substrate (1), the substrate comprising:
- a plurality of superconducting qubits or qubit parts thereof (4),
- a plurality of contact pads (5) formed of superconducting material, each pad being electrically connected to one or more of said qubits or qubit parts (4),
the method comprising the steps of:
- producing a protection layer (6) on the substrate (1) and patterning said protection layer so that the qubits and/or qubit parts (4) are covered by the protection layer (6), while the contact pads (5) are at least partially exposed, wherein the patterned protection layer has a given topography,
- producing a non-superconducting seed layer (9) on the substrate, said seed layer following the topography of the patterned protection layer (6), said seed layer being suitable as an electrically conductive layer that enables to conduct current in an electrodeposition process,
- producing a mask layer (10) on the seed layer (9), and patterning the mask layer so as to form openings (11) therein, the surface area of said openings lying within respective exposed areas of the contact pads (5),
- removing the material of the seed layer (9) from the bottom of said openings (11),
- thereafter, depositing the superconducting solder material by electrodeposition on at least part of the bottom (13) of the respective openings (11) thereby forming the solder bumps (17),
- removing the mask layer (10),
- after the electrodeposition, removing the seed layer (9) and the protection layer (6).

2. The method according to claim 1, wherein the electrodeposition is performed directly after the removal of the material of the seed layer (9) from the bottom of said openings (11), so that the seed layer contacts the solder bumps (17) in a peripheral area thereof, and wherein the mask layer (10) is removed after the formation of the solder bumps (17).

3. The method according to claim 1, wherein :
- the mask layer is a first mask layer (10) and the openings formed therein are first openings (11),
- the first mask layer (10) is removed after the step of removing the material of the seed layer (9) from the bottom of said first openings (11),
- after removing the first mask layer (10), a second mask layer (15) is produced, wherein the second mask layer is patterned so as to form second openings (16) therein, a surface area of the second openings lying within a surface area of the respective first openings (11), so that the seed layer (9) is separated from the bottom (13') of the second openings (16) by the material of the second mask layer (15),
- the electrodeposition is performed directly after the formation and patterning of the second mask layer (15), on the bottom (13') of the second openings (16), so as to form solder bumps (17) which are not in contact with the seed layer (9),
- the second mask layer (15) is removed after the formation of the solder bumps (17), followed by the removal of the seed layer (9) and of the protection layer (6).

4. The method according to any one of the preceding claims, further comprising a step of producing a layer (8) of superconducting material directly on the substrate (1) after the formation and patterning of the protection layer (6) and prior to the formation of the seed layer (9), said layer (8) of superconducting material following the topography of the patterned protection layer (6), so that the layer (8) of superconducting material is exposed at the bottom of the openings (11,16), and the solder material is deposited on the layer (8) of superconducting material, and wherein the layer (8) of superconducting material outside the solder bumps (17) is removed after the removal of the seed layer (9).

5. The method according to claim 4, wherein the layer (8) of superconducting material is a barrier layer configured to stop diffusion of solder material into the contact pads (5).

6. The method according to any one of the preceding claims, wherein the protection layer (6) is patterned so as to form openings (7) therein, the surface area of said openings lying within the surface area of the contact pads (5).

7. The method according claim 6, wherein the surface area of the openings (11) in the mask layer (10) is lying within the surface area of the openings (7) in the protection layer (6).

8. The method according to claim 6, wherein the surface area of the openings (11) in the mask layer (10) is larger than the surface area of the openings (7) in the protection layer (6), so that said openings (11) in the mask layer (10) fully overlap the openings (7) in the protection layer (6).

9. The method according to any one of claims 1 to 5, wherein the protection layer (6) is patterned so as to cover only the qubits or qubit parts thereof (4).

10. The method according to any one of the preceding claims, further comprising the production of a plurality of spacer bumps (22).

11. The method according to any one of the preceding claims, wherein the seed layer (9) is formed of copper.

12. The method according to any one of the preceding claims, wherein the solder material is indium.

## Patentansprüche

1. Herstellungsverfahren für Lötperlen (17), die aus einem supraleitenden Lötmaterial auf einem Substrat (1) gebildet werden, wobei das Substrat umfasst:
- eine Vielzahl von supraleitenden Qubits oder Qubit-Teilen davon (4),
- eine Vielzahl von Kontaktpads (5), die aus supraleitendem Material gebildet sind, wobei jedes Pad mit einem oder mehreren der Qubits oder Qubit-Teile (4) elektrisch verbunden ist,
wobei das Verfahren die folgenden Schritte umfasst:
- Herstellen einer Schutzschicht (6) auf dem Substrat (1) und Strukturieren der Schutzschicht, sodass die Qubits und/oder Qubit-Teile (4) durch die Schutzschicht (6) bedeckt sind, während die Kontaktpads (5) mindestens teilweise freiliegen, wobei die strukturierte Schutzschicht eine gegebene Topographie aufweist,
- Herstellen einer nicht-supraleitenden Keimschicht (9) auf dem Substrat, wobei die Keimschicht der Topographie der strukturierten Schutzschicht (6) folgt, wobei sich die Keimschicht als elektrisch leitende Schicht eignet, die ermöglicht, in einem elektrolytischen Abscheidungsprozess Strom zu leiten,
- Herstellen einer Maskenschicht (10) auf der Keimschicht (9) und Strukturieren der Maskenschicht, um darin Öffnungen (11) zu bilden, wobei der Oberflächenbereich der Öffnungen innerhalb der jeweiligen freiliegenden Bereiche der Kontaktpads (5) liegt,
- Entfernen des Materials der Keimschicht (9) von dem Boden der Öffnungen (11),
- danach Abscheiden des supraleitenden Lötmaterials durch elektrolytische Abscheidung auf mindestens einen Teil des Bodens (13) der jeweiligen Öffnungen (11), wodurch die Lötperlen (17) gebildet werden,
- Entfernen der Maskenschicht (10),
- nach der elektrolytischen Abscheidung, Entfernen der Keimschicht (9) und der Schutzschicht (6).

2. Verfahren nach Anspruch 1, wobei die elektrolytische Abscheidung direkt nach der Entfernung des Materials der Keimschicht (9) von dem Boden der Öffnungen (11) durchgeführt wird, sodass die Keimschicht die Lötperlen (17) in einem Randbereich davon kontaktiert, und wobei die Maskenschicht (10) nach der Bildung der Lötperlen (17) entfernt wird.

3. Verfahren nach Anspruch 1, wobei:
- die Maskenschicht eine erste Maskenschicht (10) ist und die darin gebildeten Öffnungen erste Öffnungen (11) sind,
- die erste Maskenschicht (10) nach dem Schritt des Entfernens des Materials der Keimschicht (9) von dem Boden der ersten Öffnungen (11) entfernt wird,
- nach Entfernen der ersten Maskenschicht (10) eine zweite Maskenschicht (15) hergestellt wird, wobei die zweite Maskenschicht strukturiert wird, um darin zweite Öffnungen (16) zu bilden, wobei ein Oberflächenbereich der zweiten Öffnungen innerhalb eines Oberflächenbereichs der jeweiligen ersten Öffnungen (11) liegt, sodass die Keimschicht (9) durch das Material der zweiten Maskenschicht (15) von dem Boden (13') der zweiten Öffnungen (16) getrennt ist,
- die elektrolytische Abscheidung direkt nach der Bildung und dem Strukturieren der zweiten Maskenschicht (15) auf dem Boden (13') der zweiten Öffnungen (16) durchgeführt wird, um Lötperlen (17) zu bilden, die nicht mit der Keimschicht (9) in Kontakt stehen,
- die zweite Maskenschicht (15) nach der Bildung der Lötperlen (17) entfernt wird, gefolgt von der Entfernung der Keimschicht (9) und der Schutzschicht (6).

4. Verfahren nach einem der vorstehenden Ansprüche, weiter einen Schritt zum Herstellen einer Schicht (8) aus supraleitendem Material direkt auf dem Substrat (1) nach der Bildung und dem Strukturieren der Schutzschicht (6) und vor der Bildung der Keimschicht (9) umfassend, wobei die Schicht (8) aus supraleitendem Material der Topographie der strukturierten Schutzschicht (6) folgt, sodass die Schicht (8) aus supraleitendem Material an dem Boden der Öffnungen (11, 16) freiliegt, und das Lötmaterial auf der Schicht (8) aus supraleitendem Material abgeschieden wird, und wobei die Schicht (8) aus supraleitendem Material außerhalb der Lötperlen (17) nach der Entfernung der Keimschicht (9) entfernt wird.

5. Verfahren nach Anspruch 4, wobei die Schicht (8) aus supraleitendem Material eine Barriereschicht ist, die dazu konfiguriert ist, die Diffusion von Lötmaterial in die Kontaktpads (5) zu stoppen.

6. Verfahren nach einem der vorstehenden Ansprüche, wobei die Schutzschicht (6) strukturiert wird, um darin Öffnungen (7) zu bilden, wobei der Oberflächenbereich der Öffnungen innerhalb des Oberflächenbereichs der Kontaktpads (5) liegt.

7. Verfahren nach Anspruch 6, wobei der Oberflächenbereich der Öffnungen (11) in der Maskenschicht (10) innerhalb des Oberflächenbereichs der Öffnungen (7) in der Schutzschicht (6) liegt.

8. Verfahren nach Anspruch 6, wobei der Oberflächenbereich der Öffnungen (11) in der Maskenschicht (10) größer ist als der Oberflächenbereich der Öffnungen (7) in der Schutzschicht (6), sodass die Öffnungen (11) in der Maskenschicht (10) die Öffnungen (7) in der Schutzschicht (6) vollständig überlappen.

9. Verfahren nach einem der Ansprüche 1 bis 5, wobei die Schutzschicht (6) strukturiert wird, um nur die Qubits oder Qubit-Teile davon (4) zu bedecken.

10. Verfahren nach einem der vorstehenden Ansprüche, weiter die Herstellung einer Vielzahl von Abstandsvorsprünge (22) umfassend.

11. Verfahren nach einem der vorstehenden Ansprüche, wobei die Keimschicht (9) aus Kupfer gebildet ist.

12. Verfahren nach einem der vorstehenden Ansprüche, wobei das Lötmaterial Indium ist.

## Revendications

1. Procédé de production de bosses de soudure (17) formées d'un matériau de soudure supraconducteur sur un substrat (1), le substrat comprenant :
- une pluralité de qubits supraconducteurs ou de parties de qubits de ceux-ci (4),
- une pluralité de plots de contact (5) formés d'un matériau supraconducteur, chaque plot étant connecté électriquement à un ou plusieurs desdits qubits ou desdites parties de qubits (4),
le procédé comprenant les étapes de :
- production d'une couche de protection (6) sur le substrat (1) et création de motifs dans ladite couche de protection de manière à ce que les qubits et/ou parties de qubits (4) soient recouverts par la couche de protection (6), en même temps que les plots de contact (5) sont au moins partiellement exposés, dans lequel la couche de protection à motifs présente une topographie donnée,
- production d'une couche amorce non supraconductrice (9) sur le substrat, ladite couche amorce suivant la topographie de la couche de protection à motifs (6), ladite couche amorce étant appropriée en tant que couche électriquement conductrice qui permet de conduire le courant dans un processus d'électrodéposition,
- production d'une couche de masque (10) sur la couche amorce (9), et création de motifs dans la couche de masque de manière à former des ouvertures (11) dans celle-ci, la surface desdites ouvertures se trouvant dans les zones exposées respectives des plots de contact (5),
- retrait du matériau de la couche amorce (9) du fond desdites ouvertures (11),
- ensuite, dépôt du matériau de soudure supraconducteur par électrodéposition sur au moins une partie du fond (13) des ouvertures respectives (11) formant ainsi les bosses de soudure (17),
- retrait de la couche de masque (10),
- après l'électrodéposition, retrait de la couche amorce (9) et de la couche de protection (6).

2. Procédé selon la revendication 1, dans lequel l'électrodéposition est effectuée directement après le retrait du matériau de la couche amorce (9) du fond desdites ouvertures (11), de sorte que la couche amorce entre en contact avec les bosses de soudure (17) dans une zone périphérique de celles-ci, et dans lequel la couche de masque (10) est retirée après la formation des bosses de soudure (17).

3. Procédé selon la revendication 1, dans lequel :
- la couche de masque est une première couche de masque (10) et les ouvertures formées dans celle-ci sont des premières ouvertures (11),
- la première couche de masque (10) est retirée après l'étape de retrait du matériau de la couche amorce (9) du fond desdites premières ouvertures (11),
- après avoir retiré la première couche de masque (10), une seconde couche de masque (15) est produite, dans lequel la seconde couche de masque porte des motifs de manière à former des secondes ouvertures (16) sur celle-ci, une surface des secondes ouvertures se trouvant à l'intérieur d'une surface des premières ouvertures respectives (11), de sorte que la couche amorce (9) soit séparée du fond (13') des secondes ouvertures (16) par le matériau de la seconde couche de masque (15),
- l'électrodéposition est réalisée directement après la formation de et la création de motifs dans la seconde couche de masque (15), sur le fond (13') des secondes ouvertures (16), de manière à former des bosses de soudure (17) qui ne sont pas en contact avec la couche amorce (9),
- la seconde couche de masque (15) est retirée après la formation des bosses de soudure (17), suivie du retrait de la couche amorce (9) et de la couche de protection (6).

4. Procédé selon l'une quelconque des revendications précédentes, comprenant en outre une étape de production d'une couche (8) de matériau supraconducteur directement sur le substrat (1) après la formation de et la création de motifs dans la couche de protection (6) et avant la formation de la couche amorce (9), ladite couche (8) de matériau supraconducteur suivant la topographie de la couche de protection à motifs (6), de sorte que la couche (8) de matériau supraconducteur soit exposée au fond des ouvertures (11, 16), et le matériau de soudure est déposé sur la couche (8) de matériau supraconducteur, et dans lequel la couche (8) de matériau supraconducteur à l'extérieur des bosses de soudure (17) est retirée après le retrait de la couche amorce (9).

5. Procédé selon la revendication 4, dans lequel la couche (8) de matériau supraconducteur est une couche barrière configurée pour arrêter la diffusion du matériau de soudure dans les plots de contact (5).

6. Procédé selon l'une quelconque des revendications précédentes, dans lequel la couche de protection (6) porte des motifs de manière à former des ouvertures (7) dans celle-ci, la surface desdites ouvertures se trouvant à l'intérieur de la surface des plots de contact (5).

7. Procédé selon la revendication 6, dans lequel la surface des ouvertures (11) dans la couche de masque (10) se situe à l'intérieur de la surface des ouvertures (7) dans la couche de protection (6).

8. Procédé selon la revendication 6, dans lequel la surface des ouvertures (11) dans la couche de masque (10) est plus grande que la surface des ouvertures (7) dans la couche de protection (6), de sorte que lesdites ouvertures (11) dans la couche de masque (10) chevauchent entièrement les ouvertures (7) dans la couche de protection (6).

9. Procédé selon l'une quelconque des revendications 1 à 5, dans lequel la couche de protection (6) porte des motifs de manière à recouvrir uniquement les qubits ou parties de qubits de ceux-ci (4).

10. Procédé selon l'une quelconque des revendications précédentes, comprenant en outre la production d'une pluralité de bosses d'espacement (22).

11. Procédé selon l'une quelconque des revendications précédentes, dans lequel la couche amorce (9) est formée de cuivre.

12. Procédé selon l'une quelconque des revendications précédentes, dans lequel le matériau de soudure est l'indium.
